# EUROPEAN PATENT APPLICATION

(11) **EP 4 782 794 A2**
(43) Date of publication of application: **29.07.2026**
(21) Application number: 26152153.8
(22) Date of filing: 15.01.2026
(51) Int. Cl.: G01D 21/00, G01D 11/30, G01D 11/24

(54) **SMART SENSOR MOUNT SYSTEMS**

(30) Priority: 22.01.2025 US 202563748239 P; 12.01.2026 US 202619446598
(71) Applicant: HellermannTyton Corporation, Milwaukee, WI 53224 (US)
(72) Inventor: Friedli, Joseph, New Berlin, Wisconsin (US); Toll, Michael, Whitefish Bay, Wisconsin (US)
(74) Representative: Hernandez, Yorck

(57) **Abstract**

A sensing system includes an attachment module configured to attach to an object and a housing module. The attachment module comprises a first side opposite a second side and a mounting member having a first retainer portion defined on the first side and a second retainer portion defined on the second side. The housing module comprises at least one second retainer configured to connect to the first retainer to connect the attachment module to the housing module. The second retainer includes a third retainer portion configured to connect with the first retainer portion and a fourth retainer portion configured to connect with the second retainer portion. This configuration facilitates the mounting of sensing components to objects, such as conduits or cables, for monitoring environmental or physical variables.

## Description

### INCORPORATION BY REFERENCE

This application claims the benefit of U.S. Provisional Application No. 63/748,239, filed 01/22/2025, the disclosure of which is incorporated herein by reference.

### BACKGROUND

Industrial and commercial environments frequently utilize sensing systems to monitor environmental variables, such as temperature, fluid flow, and electrical current. Certain sensing arrangements, such as clamp-on flow meters, often involve multiple discrete components, including brackets and screws, to achieve installation. The assembly of these multi-component systems presents complexity during installation. Incorrect assembly or positioning of these fastening elements can result in suboptimal coupling between the sensor and the object, potentially affecting the accuracy of the sensing results.

### SUMMARY

This document describes techniques and apparatuses for smart sensor mount systems, also referred to herein as "sensor systems." The sensor systems described herein provide a modular platform for environmental monitoring across diverse physical infrastructures. Some of the sensory systems include a universal housing module configured to enclose electronic components, which is interchangeably connectable to a plurality of distinct attachment modules. In one implementation, the attachment module comprises a ratcheting clamp for securing the system to elongated objects like pipes or cables. In another implementation, the attachment module comprises a cord grip configured for installation in an enclosure orifice. This modular architecture allows the same sensing and data processing "brain" to be deployed in different physical environments (e.g., on external piping or at the entry point of an electrical cabinet), while maintaining a consistent electronic interface and notification protocol.

In aspects, the sensor systems include an attachment module configured to detachably or adjustably secure to the object and a housing module that encloses electronic components. The housing module and the attachment module are configured to connect via a secure attachment mechanism, such as a snap-fit connection utilizing corresponding retainer portions. By integrating modular sensing, data processing, and notification capabilities into a single system, the sensor system addresses the need for a mounting and sensing solution that is adjustable to various object sizes while providing local or remote status alerts without requiring complex assembly or permanent infrastructure modifications.

One aspect of the sensor system includes a first retainer portion defined on a first side of the attachment module and a second retainer portion defined on an opposite second side. The housing module includes at least one second retainer configured to connect to the first retainer to join the modules. In some implementations, the housing module contains a controller, a communication module, and a notification module. The controller is configured to receive and process sensor signals from at least one sensor module. Processing the sensor signals may include comparing the signals to a threshold value. Responsive to a determination that the sensor signals exceed the threshold, the controller can generate a notification signal. The notification module provides a notification to a user, which can include an auditory alarm, a vibratory alarm, a visual alarm such as a light-emitting diode (LED) or a display output, or a notification message delivered to an application on a computing device (e.g., user device).

In certain implementations, the cord grip and housing module facilitate monitoring of internal environments, such as the interior of an electrical cabinet, while providing a communicative interface to the external environment. This configuration enables the sensor system to operate as a self-contained, non-invasive monitoring solution that functions independently of the internal power supply or control systems of the enclosure. By decoupling the sensing logic from the enclosure's internal circuitry, the system reduces installation complexity, eliminates the need for network administrator intervention, and enhances safety by allowing data retrieval and status monitoring to occur externally without opening the enclosure door.

Another aspect of the described sensor systems includes a cord grip configured for installation in an orifice to protect a cable extending therethrough. The cord grip includes a connector defined in a sidewall that is communicatively coupled to a communication module. This connector is configured to communicatively connect with an external component, such as an antenna for transmitting radio frequency signals to a computing device or an external notification module. In certain implementations, the cord grip facilitates monitoring of internal environments, such as the interior of an electrical cabinet, while providing an interface to the external environment. This configuration allows the sensor system to operate independently of the internal power supply or control systems of the enclosure being monitored.

The described sensor systems further include various modular sensor configurations. For example, a sensor module can be integrated within the housing module or located externally and connected via a cable and data interface. Some implementations utilize a sensor insert positioned between the attachment module and the object. The communication module may include a wireless communication module configured to transmit sensor signals, processed data, or notifications to a computing device. This modularity enables the sensor system to be customized for diverse applications, ranging from industrial equipment monitoring to infrastructure management.

This Summary is provided to introduce simplified concepts of techniques and apparatuses for smart sensor mount systems, which are further described below in the Detailed Description and are illustrated in the Drawings. This Summary is not intended to identify all implementations of the techniques and apparatuses described in the Detailed Description and illustrated in the Drawings and is not intended to identify essential features of the claimed subject matter. Further, this Summary is not intended for use in determining the scope of the claimed subject matter.

### BRIEF DESCRIPTION OF THE DRAWINGS

The details of one or more implementations of techniques and apparatuses for smart sensor mount systems are described with reference to the following Drawings.
FIG. 1 is a schematic representation of example environments in which smart sensor mount systems can be implemented.
FIG. 2 is a block diagram illustration of an example of a smart sensor mount system.
FIG. 3 is a schematic representation of an example smart sensor mount system of FIG. 2.
FIG. 4 is a schematic representation of an example smart sensor mount system of FIG. 2.
FIG. 5 is a schematic representation of an example smart sensor mount system of FIG. 2.
FIG. 6A is a perspective view of an example smart sensor mount system of FIG. 2.
FIG. 6B is a side view of the example smart sensor mount system of FIG. 2 with the attachment module in an open position.
FIG. 6C is a side view of the example smart sensor mount system of FIG. 2 with the attachment module in a closed position.
FIG. 6D is an exploded view of the example smart sensor mount system of FIG. 6A.
FIG. 6E is a bottom perspective view of an attachment module of the example smart sensor mount system of FIG. 6A.
FIG. 6F is a top perspective view of the attachment module of the example smart sensor mount system of FIG. 6A.
FIG. 6G is a first top perspective view of the housing module of the example smart sensor mount system of FIG. 6A.
FIG. 6H is a second top perspective view of the housing module of the example smart sensor mount system of FIG. 6A.
FIG. 6I is a bottom perspective view of a second attachment module.
FIG. 7A is a schematic illustration of an example smart sensor mount system.
FIG. 7B is a schematic illustration of an example smart sensor mount system.
FIG. 7C is a schematic illustration of an example smart sensor mount system.
FIG. 8A is a first perspective view of a cord grip of an example smart sensor mount system.
FIG. 8B is a second perspective view of the cord grip of FIG. 8A.

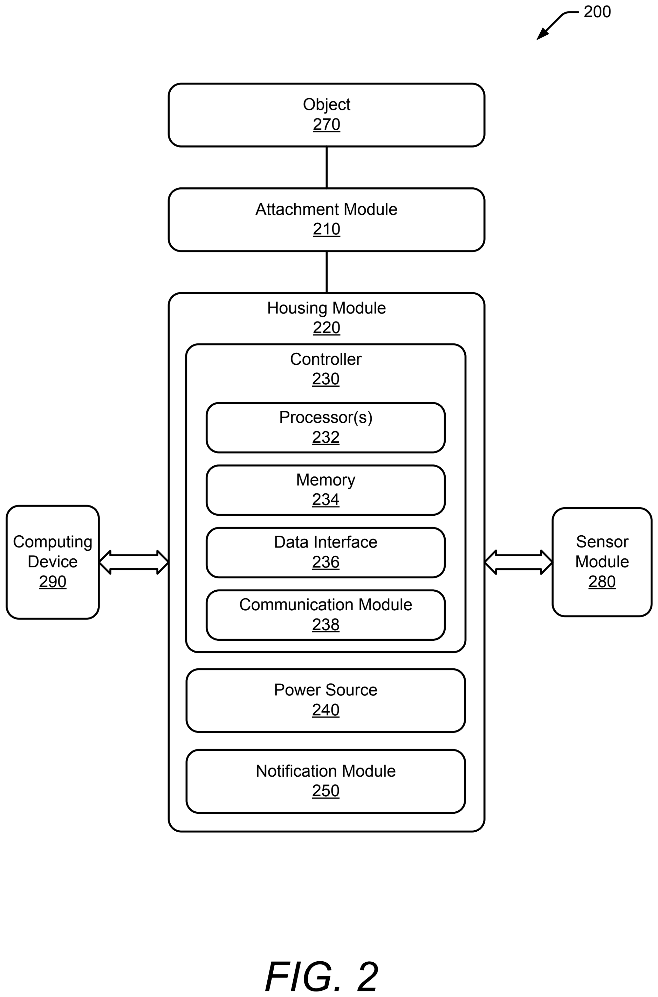

In the Detailed Description, the first digit of a reference character (e.g., call-out number) may correlate with the first figure number in which the reference character is labeled. For example, reference characters that start with a "2" (e.g., controller 230, memory 234) may represent details first called out with respect to FIG. 2. Further, the same reference characters in different Drawings may identify the same or similar features, elements, and/or parts.

### DETAILED DESCRIPTION

Described herein are implementations of improved techniques and apparatuses for smart sensor mount systems.

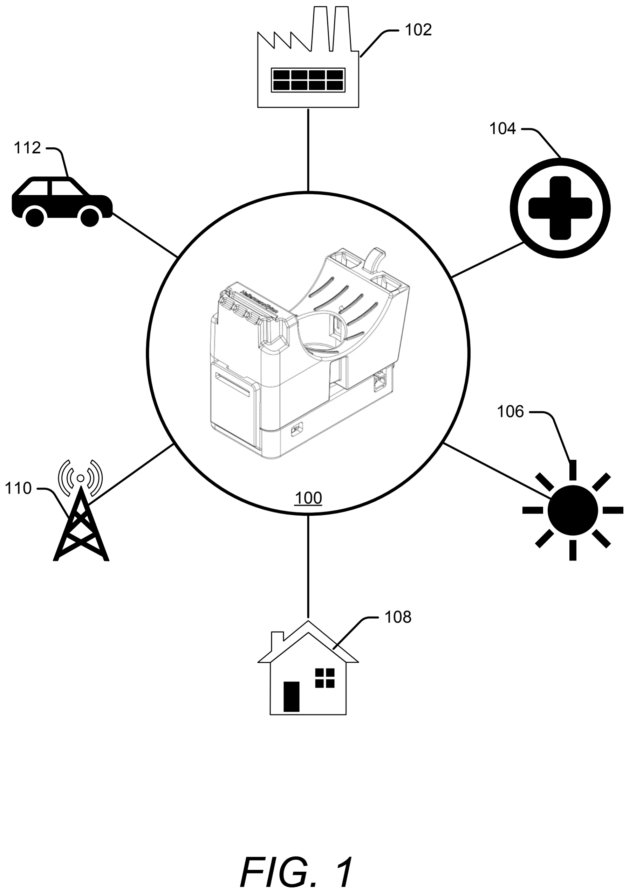

FIG. 1 is a schematic representation of example environments in which a smart sensor mount system 100 (sensor system 100) can be implemented. As discussed herein, the smart sensor mount systems 100 may have particular application in the industrial and manufacturing markets 102 (e.g., monitoring environmental variables and providing notifications to users). While this disclosure, including the Drawings, references these markets, the smart sensor mount systems 100 may have application to monitoring environmental variables in other markets, including but not limited to healthcare markets 104, energy and utility markets 106, consumer and commercial markets 108, telecommunications and data infrastructure markets 110, and/or transportation markets 112.

The industrial and manufacturing markets 102 include industrial automation and equipment, control panels, machine building, machinery, electrical enclosures, material handling systems (e.g., conveyors), cooling systems, heavy equipment (e.g., construction and mining machinery), agricultural technology (e.g., farming equipment), chemical (e.g., chemical processing equipment), robotics (e.g., automated robotic systems), original equipment manufacturers (OEMS), mechanical components, and mechanical systems. The healthcare markets 104 include medical equipment and technology, and dental equipment and technology. The energy and utility markets 106 include renewable energy systems (e.g., solar panels, solar arrays, wind turbines, hydroelectric generators), power generation and distribution, industrial lighting, and commercial lighting. The energy and utility markets 106 also include photovoltaic systems that include one or more panels (e.g., solar panels) of photovoltaic cells mounted on a support structure where the electrical output of the solar panels is transferred to the electrical grid or an electrical storage device (e.g., battery) through one or more electrical cables (photovoltaic cables).

The consumer and commercial markets 108 include appliances (e.g., home and commercial appliances), heating, ventilation, and air conditioning (HVAC), and consumer electronic devices. The telecommunications and data infrastructure markets 110 include telecommunications (e.g., general telecom services), communications (e.g., communication systems and equipment), internet service providers (ISPs), cable television companies (CATV), infrastructure for data storage and processing (e.g., data centers), broadband (e.g., broadband internet services), and datacom (e.g., data communications equipment). The transportation markets 112 include manufacturing and components for vehicles, trucks, automobiles, rail conveyances (e.g., trains), marine craft (e.g., ships, boats), aircraft, and aerospace.

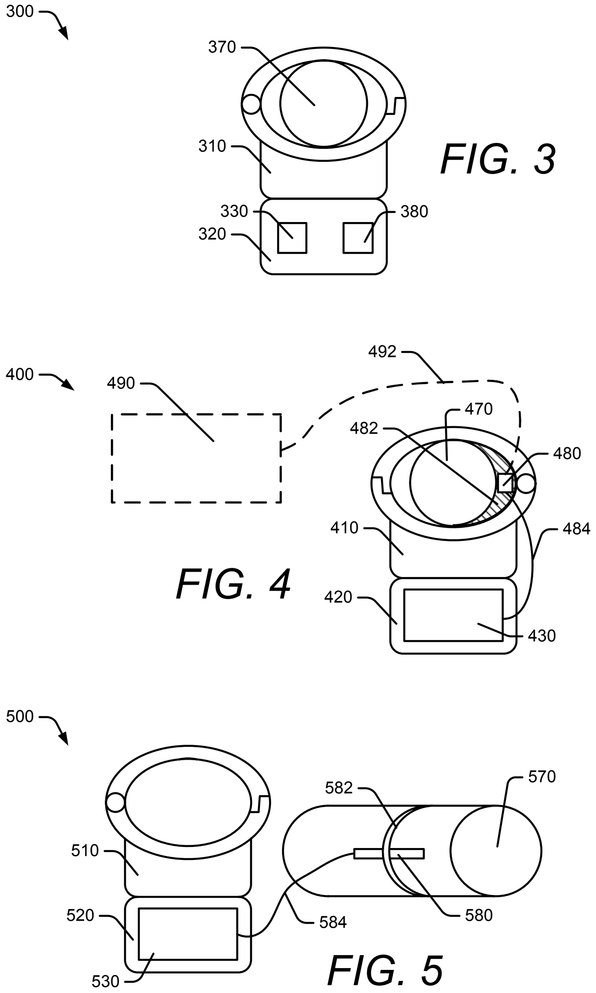

FIG. 2 is a block diagram illustration of an example of a smart sensor mount system 200. The smart sensor mount system 200 (sensor system 200) is similar to the sensor system 100 illustrated in FIG. 1 and described above, except as detailed below. The sensor system 200 is configured for attachment to an object 270 through an attachment module 210. As used herein, the term "object" is used to refer to all types and forms of objects, including, but not limited to cabinets, housings, frames, enclosures, panels, cables, wires, wire harnesses, hydraulic lines, pneumatic lines, hoses, optical fiber, pipes, tubing, conduits, and bundles of one or more of the same. An object may be elongated. While the in this Description and the Drawings, a length of pipe or cable is frequently used as an example object, other types of objects may be substituted. Examples of attachment modules 210 include, but are not limited to, clamps, clips, mounts, routing clamps, routing clips, bracket clamps, saddle mounts, cradles, ratchet clamps, ratchet clamps (e.g., as illustrated in FIGS. 3-6F), Modular Omega Clips (MOCs), and the like. An attachment module 210 may include a curved geometry that provides additional support for the object (e.g., for a bundle) and/or the attachment module 210 may be configured for adjustment to enable the attachment module 210 to be attached to a wide range of object sizes (e.g., pipe diameters, cable diameters, bundle diameters). In aspects, the attachment module may be omitted.

The sensor system 200 includes a housing module 220 that is configured to enclose and/or protect at least one electronic component (e.g., a controller 230, a communication module 238, a power source 240, a notification module 250, a sensor module 280) of the sensor system 200. The housing module 220 may include, at least in part, a translucent, semi-translucent, and/or transparent portion that is configured to permit a notification light (e.g., from a notification module 250) to be visible to a user.

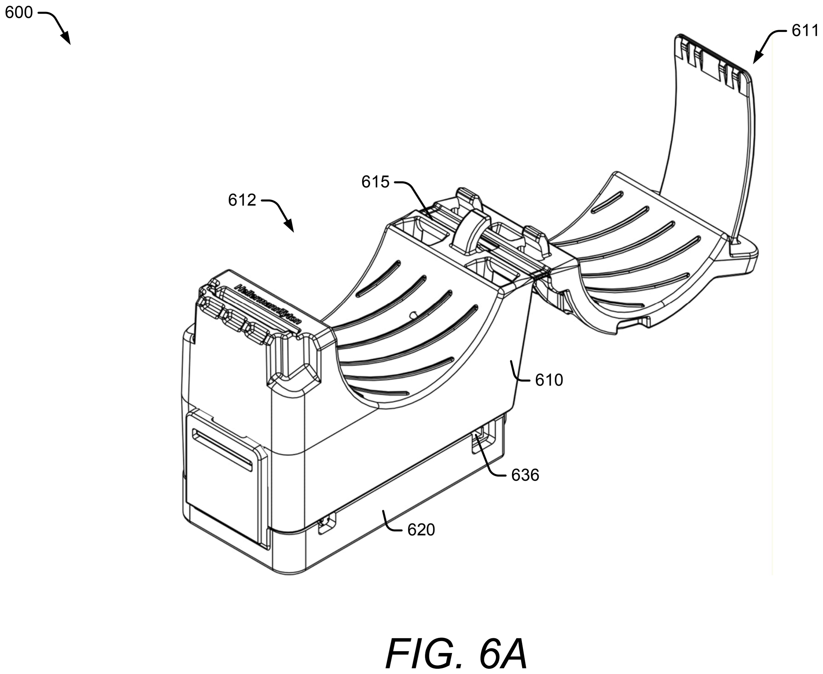

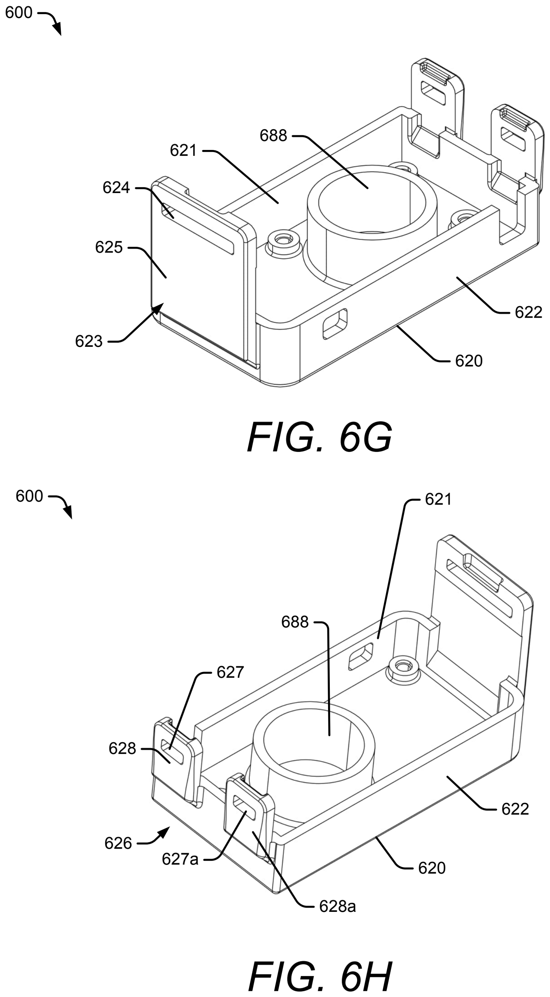

The housing module 220 is configured to attach to the attachment module 210 through an attachment mechanism. In this way, the attachment mechanism may detachably secure the housing module 220 to the attachment module 210. The attachment mechanism includes any suitable mechanism configured to attach the housing module to the attachment module 210, including but not limited to fasteners, snap-fit connections, adhesive fasteners (e.g., a double-sided adhesive tape, a double-stick adhesive foam, a pressure-sensitive adhesive tape, and the like), magnets, friction fits, and the like, and combinations thereof (e.g., a fastener and an adhesive fastener, an adhesive fastener and a magnet), and/or any other fastening method that ensures secure and detachable attachment to the attachment module 210. In the aspect illustrated in FIGS. 6A-6H and described below, the housing module 220 is configured to clip onto the attachment module 210 (e.g., to a bottom side of the attachment module 210, as illustrated in FIGS. 6A-6C). In FIGS. 6A-6H, the attachment mechanism (discussed in detail below) is a snap-fit connection. In aspects, the housing module may be omitted.

The controller 230 (e.g., a programmable logic controller (PLC)) may be housed within the housing module 220 and may include electronic components configured for one or more functions of the sensor system 200. In other aspects, the controller 230 may be external to the housing module 220. The controller 230 may include a processing unit (e.g., processor(s) 232) configured to receive signals from the sensor module 280, process these signals, and communicate the processed data via the communication module 238 (e.g., to a computing device 290). The processing unit may include one or more of an electronic control unit, a microcontroller, a microprocessor, or any other suitable processing unit capable of performing the functions described herein. In aspects, the processor(s) may be omitted.

The controller 230 is configured for data processing and handling. The controller 230 may enable the interpretation of sensor data. The controller 230 may be configured to receive sensor signals (sensor data) generated by at least one sensor (e.g., the sensor module 280) and process the sensor signals to generate processed signals. The sensor signals and/or processed signals can be used by the system to generate a notification on the notification module 250. The controller 230 may be configured to receive sensor signals generated by the sensor module 280 and process the sensor signals to: compare the sensor signals to a threshold value to determine if the sensor signals exceed a threshold, and responsive to a determination that the sensor signals exceed the threshold, generate a notification signal. The controller 230 may send the notification signal to the notification module 250 (described below). The notification signal may trigger one or more of: an auditory alarm output by an electroacoustic transducer of the notification module 250; a vibratory alarm output by a vibration mechanism of the notification module 250; a visual alarm output by a light emitter of the notification module 250; a visual alarm output on a display of the notification module 250; or a notification message delivered to an application installed on a user device (e.g., computing device 290).

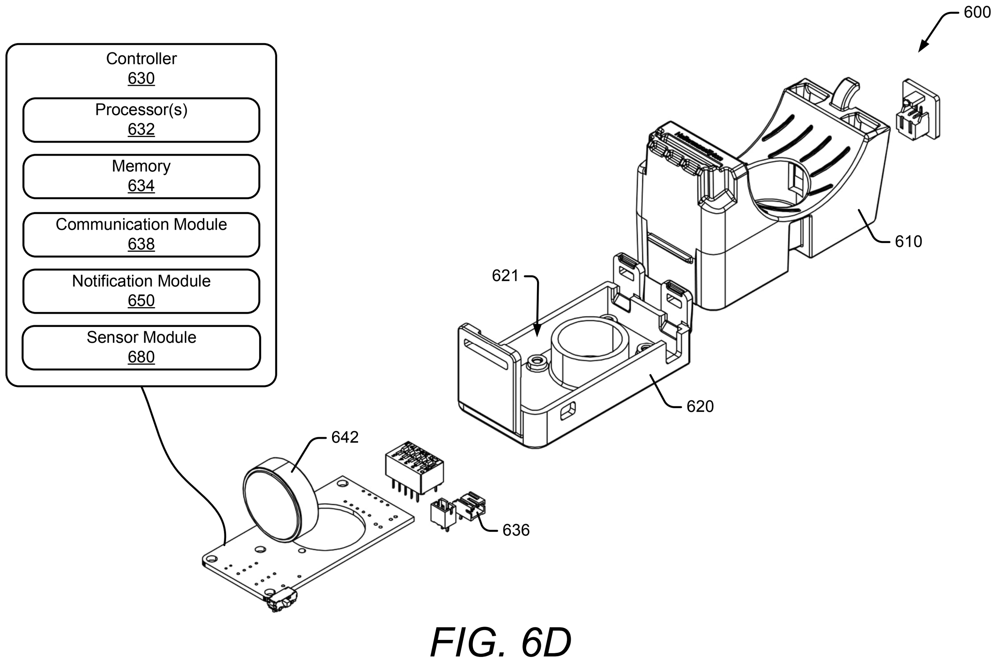

The controller 230 may be configured to control the communication module 238 to communicate at least one of the sensor signals or the processed signals. The controller 230 may be implemented on at least one printed circuit board (PCB), for example the PCB as illustrated in FIG. 6D as controller 630. The controller 230 may be implemented within the notification module 250. The controller 230 may include dual in-line package (DIP) switches and the like for setting data thresholds. In aspects, the controller may be omitted.

The controller 230 may include memory 234 configured to store data (e.g., sensor data). The term "memory," as used herein, can include computer readable memory, and may be volatile memory and/or non-volatile memory. Non-volatile memory can include, for example, ROM (read only memory), PROM (programmable read only memory), EPROM (erasable PROM), and EEPROM (electrically erasable PROM). Volatile memory can include, for example, RAM (random access memory), synchronous RAM (SRAM), dynamic RAM (DRAM), and synchronous DRAM (SDRAM). The memory can store an operating system and/or instructions executable by a processor or controller or the like to enable control or allocate resources of a computing device. In aspects, the memory 234 may be omitted. The controller 230 may function as a datalogger that logs data (e.g., output signals generated by the sensor module 280) over time and stores the logged data in the memory 234.

The controller 230 may include at least one data interface 236 that is implemented to communicate data (e.g., between the controller 230 and the computing device 290 and/or the sensor module 280). The data interface 236 may include a device connector (e.g., a pin connector, a Japan Solderless Terminal (JST) connector, a barrel connector, a USB connector, and the like). In the example illustrated in FIGS. 6A-6D, the data interface 236 includes an external JST connector configured to connect with a cable (e.g., a cable of the sensor module 280). The data interface 236 may be used for internal sensors and/or external sensors.

The controller 230 may include a communication module 238 configured to enable wired or wireless data communication of information (e.g., signals, sensor signals, data) between the controller 230 and external devices (e.g., computing device 290, sensor module 280, notification module 250). In aspects, the communication module 238 is separate from the controller 230. The information may include one or more sensor signals generated by at least one sensor module, sensor signals processed by the controller (e.g., processed signals), stored sensor data, notification signals (e.g., a notification) generated by the notification module, and the like. The communication module 238 may communicate via any wired or wireless connection and/or communication protocol (e.g., ethernet, fiberoptic, Bluetooth^{®}, Bluetooth^{®} Low Energy (BLE), ZigBee, Z-wave, Thread, low power wide-area networks (e.g., Long Range WAN (LoRaWAN)), dedicated short-range communications (DSRC), internet-of-things (IoT), Ultra-Wide Band (UWB), code division multiple access (CDMA), Global System for Mobile Communications (GSM), Enhanced Data GSM Environment (EDGE), Long Term Evolution (LTE), wireless local area network (such as IEEE 802.11a, IEEE 802.11b, IEEE 802.11g, and/or IEEE 802.11n), and the like). In this way, the communication module 238 may be a wired communication module and/or a wireless communication module. Through the connection of the computing device 290 with the controller 230 via the communication module 238, data (e.g., live data) may be accessed. In aspects, the communication module may be omitted.

The power source 240 is configured to provide electrical energy to one or more components of the sensor system 200. Examples of power sources 240 include, but are not limited to, mains power (e.g., alternating current (AC) power), batteries, rechargeable batteries, alkaline batteries, solar cells, or any other suitable power supply. The controller 230 may include electronics configured for mains and/or Universal Serial Bus (USB) charging rechargeable batteries (e.g., power management circuitry). The power source 240 may be located within the housing module 220. In aspects, the power source may be omitted.

The notification module 250 is configured to provide a notification to a user and/or a computing device. The notification(s) may indicate sensor values, environmental conditions, statuses, and the like. A notification module 250 may include one or more of an electroacoustic transducer (e.g., loudspeaker) configured to generate an auditory alarm output (e.g., sounds), a vibration mechanism (e.g., piezo buzzer) configured to generate a vibratory alarm output (e.g., vibrations), a light emitter (e.g., light emitting diode) configured to generate a visual alarm output (e.g., light color(s), changes to light color(s), light blink rates), a display (e.g., the display of a computing device) that is configured to provide a visual alarm output (e.g., a user interface on the display), and/or a notification message delivered to an application installed on a computing device or other external device. Example notifications include an auditory alarm output by an electroacoustic transducer, a vibratory alarm output by a vibration mechanism, a visual alarm output by a light emitter (e.g., light emitting diode), a visual alarm output on a display (e.g., of a user device), or a notification message delivered to an application installed on a user device (e.g., computing device 290), and the like.

The notification module 250 may be integrated into (e.g., disposed in) the housing module 220. In aspects, the notification module 250 or components thereof (e.g., a light emitter) is visible through a translucent, semi-translucent, and/or transparent portion of the housing module 220. In other aspects, the notification module 250 may be external to and separate from the housing module 220 and in such an implementation, the notification module 250 may be located within a housing that includes, at least in part, a translucent, semi-translucent, and/or transparent portion that is configured to permit a notification light to be visible to a user.

The notification module 250 may include a controller (e.g., controller 230) that is configured to receive sensor signals generated by the sensor module 280 and process the sensor signals to: compare the sensor signals to a threshold value to determine if the sensor signals exceed a threshold, and responsive to a determination that the sensor signals exceed the threshold, generate the notification signal. The term "threshold" as used herein denotes a reference value, a level, a point, or a range of values, for which, when a value of a sensor signal is above it (or below it depending on a particular use case), the system may follow a first course of action (e.g., generate a notification signal) and, when the value of the sensor signal is below it (or above it depending on a particular use case), the system may follow a second course of action (e.g., take no action).

In another aspect, the controller e.g., controller 230) is configured to receive sensor signals generated by the sensor module 280 and process the sensor signals to: compare the sensor signals to a threshold value to determine if the sensor signals deviate from a baseline (e.g., indicate a temperature below freezing, indicate differences in vibration profiles), and responsive to a determination that the sensor signals deviate from a baseline, generate the notification signal. The term "baseline" as used herein denotes initial measurement of an environmental variable that is taken at an early time point and used for comparison over time to look for changes.

In other aspects, the notification module 250 receives the notification signal from the controller 230. The notification signal may trigger one or more of: an auditory alarm output by an electroacoustic transducer of the notification module; a vibratory alarm output by a vibration mechanism of the notification module; a visual alarm output by a light emitter of the notification module; a visual alarm output on a display of the notification module; or a notification message delivered to an application installed on a computing device. In aspects, the notification module may be omitted.

The sensor module 280 is configured to monitor environmental variables associated with the object 270. The sensor module 280 may include one or more sensors. Examples of sensors include but are not limited to, temperature sensors (e.g., ambient air temperature sensor, cable temperature sensor), ultrasonic mems (micro-electromechanical systems), microphones, mems microphones, current transducers, thermistors, and the like. The sensor module 280 may be integrated within the housing module 220 and/or may be external to the housing module 220. In aspects, the sensor module may be omitted.

The sensor system 200 may include at least one a computing device 290. The term "computing device" encompasses any device that receives data from the controller 230 (e.g., via the communication module 238, via the data interface 236). This includes, but is not limited to, smartphones, tablets, computers, or any other electronic devices capable to receive and/or display the transmitted data. Example external devices may include a smartphone configured to run a dedicated mobile application or a cloud server that stores and analyzes the data for remote monitoring, research, and other applications. The computing device 290 may be configured to enable the management of temperature threshold configurations and settings, for example through a mobile application. The mobile application may also enable the downloading of historical data from the controller 230. The computing device may include one or more routers or bridges (e.g., a Bluetooth Low Energy gateway device) that enables the data to be accessed globally from a Message Queuing Telemetry Transport (MQTT) broker to an existing data system. In aspects, the computing device may be omitted.

FIGS. 3-5 are schematic block diagram illustrations of example smart sensor mount systems (sensor system 300, sensor system 400, sensor system 500). The sensor systems are similar to the sensor mount systems illustrated in FIGS. 1 and 2, which are described above, except as detailed below. FIGS. 3-5 show the versatility of disclosed sensor systems.

In FIG. 3, the sensor system 300 includes an attachment module 310 that is configured to attach to an object 370 (e.g., pipe, cable), a housing module 320 that is configured to attach to the attachment module 310, and a controller 330 configured to control the sensor system 300. In the aspect illustrated in FIG. 3, the sensor module 380 is located within the housing module 320 and the attachment module 310 is a ratchet clamp fixing, as illustrated and described in detail with respect to FIGS. 6A-6H. In other aspects, the sensor module 380 may be external to the housing module 320 (e.g., the sensor module 480 of FIG. 4, the sensor module 580 of FIG. 5).

In FIG. 4, the sensor system 400 includes an attachment module 410 that is configured to attach to an object 470 (e.g., cable, pipe), a housing module 420 that is configured to attach to the attachment module 410, a controller 430 configured to control the sensor system 400, and a sensor module 480. Similar to the sensor system of FIG. 3, the attachment module 410 is a ratchet clamp fixing, as illustrated and described in detail with respect to FIGS. 6A-6H. The sensor module 480 includes a sensor insert 482 that is configured for receipt between the first and second connectors of the ratchet clamp fixing and the object 470 to position the sensor relative to the object. The sensor insert 482 may include a form-fitting insert (e.g., strip of foam, foam pad, compressible portion).

The sensor module 480 is illustrated as connected to the controller 430 via cable 484 or, alternatively, to a computing device 490 (e.g., an existing PLC system or controller) via cable 492 to interpret the data. Advantages of the FIG. 4 configuration include the ability to swap sensor types (e.g., temperature, current, sound) and the flexibility of mounting the sensor module to a wide range of cable/pipe diameters with a single mount.

FIG. 5 illustrates the use of the sensor system with an external sensor. The sensor system 500 includes an attachment module 510, a housing module 520 that is configured to attach to the attachment module 510, the housing module 520 includes a controller 530 configured to control the sensor system 500, and a sensor module 580. The controller 530 is configured to operably connect via a cable 584 to a sensor module 580. The cable 584 may plug into an external JST connector (e.g., the data interface 636 described below) on the housing module 520. The sensor module 580 is configured to attach to an object 570 (e.g., cable, pipe). For example, the sensor 580 may attach to the object 570 via a strap 582 (e.g., a cable tie) or the like.

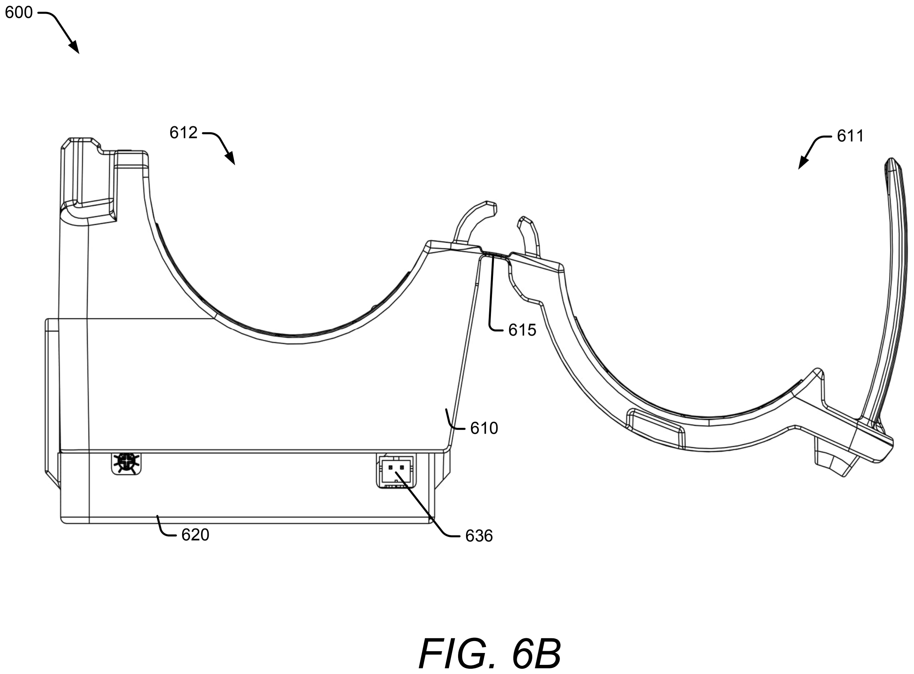

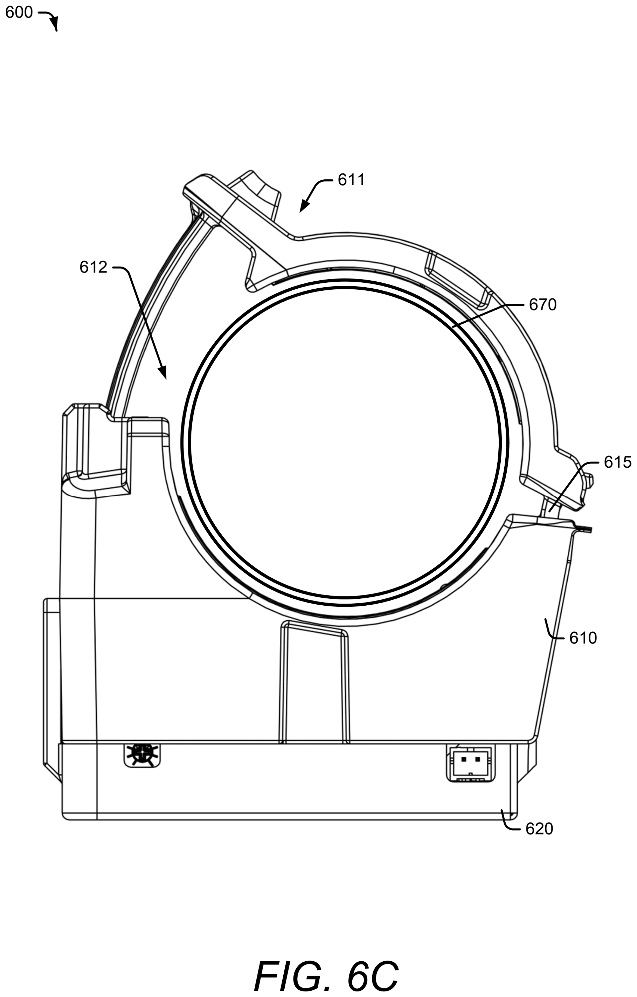

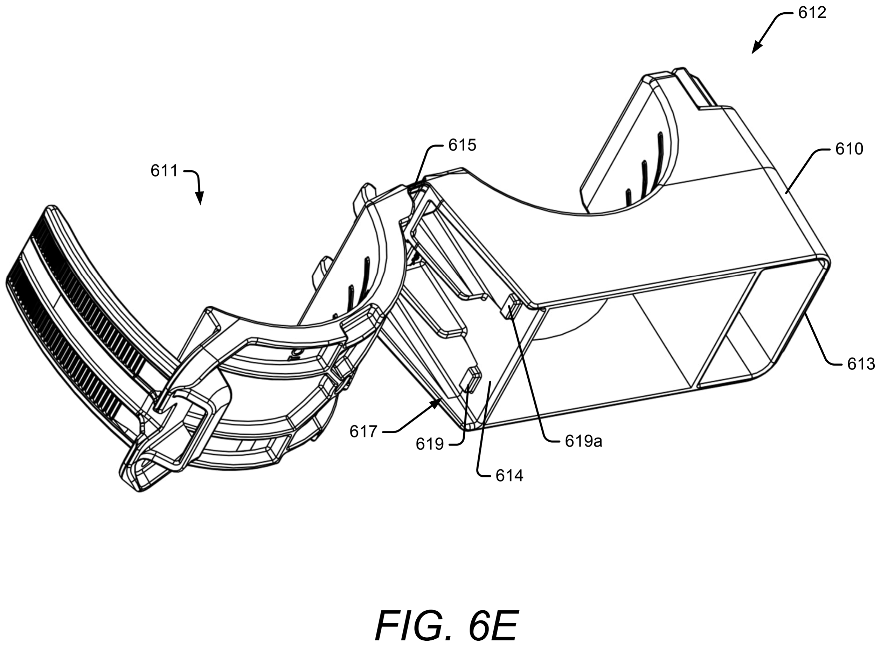

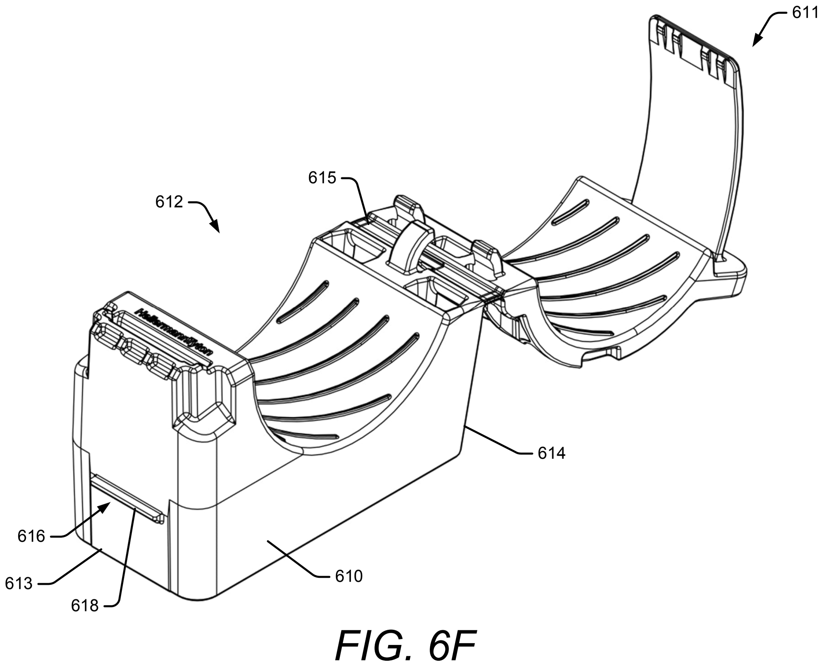

Referring now to FIGS. 6A-6H, another aspect of a smart sensor mount system 600 (sensor system 600) is illustrated. The sensor system 600 is similar to the sensor systems illustrated in FIGS. 1 and 2, and described above, except as detailed below. Thus, the sensor system 600 includes one or more of an attachment module 610, a housing module 620, a controller 630, processor(s) 632, memory 634, a data interface 636, a communication module 638, a power source 642, a notification module 650, and/or a sensor module 680. In FIG. 6D, the attachment module 610 is illustrated in part (e.g., without the first connector 611), with the full attachment module 610 illustrated in FIGS. 6A, 6B, 6C, 6E, and 6F. The housing module 620 may define a cavity 621 therein, which is configured to receive the controller 630.

The attachment module 610 is configured to connect with an object (e.g., object 670). For example, the object may be a pipe that the attachment module clamps around. In one example, the attachment module 610 is similar to the mounting clamp disclosed in US 2025/0122956 A1, titled "Snap-On Bracket Clamp Assemblies," published on April 17, 2025, the disclosure of which is incorporated by reference.

As illustrated in FIGS. 6A, 6B, 6C, 6E, and 6F, the attachment module 610 includes a first connector 611 hingedly connected at a first end via a hinge member 615 to a second connector 612 at a first end. The first connector 611, hinge member 615, and second connector 612 may be integrally formed through an injection molding process or another suitable process. In FIGS. 6A, 6B, 6D, 6E, and 6F, the attachment module 610 is illustrated in an open position. Opposing second ends of the first and second connectors include locking mechanisms that are configured to engage to lock the attachment module 610 onto the object 670. For example, the second end of the first connector 611 includes a serrated tongue configured to engage with a ratchet pawl in the second end of the second connector 612. In this way, the position of the first connector 611 can be locked relative to the position of the second connector 612. The positions may be locked in one or more locked positions to enable the attachment module 610 to be adjusted to receive one or more objects of varying sizes or diameters therein. In such a configuration, the attachment module 610 is in a closed position, as illustrated in FIG. 6C.

The connector (e.g., at least one of the first connector 611 or the second connector 612) defines a passageway configured or shaped to enclose at least a portion of the object 670. The first connector 611 defines a first passageway that is configured to enclose at least a portion of the object 670 and the second connector 612 defines a second passageway that is configured to enclose the at least a portion of the object 670. The first passageway may align with the second passageway when the first connector 611 and the second connector 612 are positioned in a clamped position to form a passageway that encloses the at least a portion of the object 670 when the attachment module 610 is in the closed position. In aspects, the first and second connectors may define matching curved first and second passageways that are substantially symmetrical and/or are shaped to enclose at least a portion of the object 670 to engage and retain the object 670.

The attachment module 610 includes a first side 613 opposite a second side 614. The first side 613 defines a first retainer portion 616 and the second side 614 defines a second retainer portion 617. In the aspect illustrated in FIGS. 6E and 6F, the first retainer portion 616 is an elongated ridge 618 that extends from the first side 613 and the second retainer portion 617 is a pair of spaced elongated ridges (619, 619a) that extend from the second side 614.

The housing module 620 is configured to connect to the attachment module 610 (e.g., configured to snap onto the attachment module 610). The housing module 620 includes a body 622 configured to connect with the attachment module 610. The body 622 may include at least one third retainer portion 623 configured to connect to the first retainer portion 616 (e.g., ridge 618) to connect the housing module 620 to the attachment module 610. The body 622 may include at least one fourth retainer portion 626 configured to connect to the second retainer portion 617 (e.g., ridge 619, ridge 619a) to connect the housing module 620 to the attachment module 610.

The third retainer portion 623 may include at least one cantilever arm (first arm 625) that extends from the body 622. At least one slot (slot 624) may be defined in the first arm 625 and configured to receive the ridge 618 therein. In this way, the first arm 625 is configured to flex relative to the body 622 to enable a snap-fit connection between the first retainer portion 616 of the housing module 620 and the third retainer portion 623 of the attachment module 610.

The fourth retainer portion 626 may include at least one cantilever arm (second arm 628, third arm 628a) that extends from the body 622. At least one slot (slot 627, slot 627a) may be defined in the respective second arm 628 and third arm 628a and configured to receive the respective ridges (ridge 619, ridge 619a) of the second receiving portion 617 therein. In this way, the second and third arms are configured to flex relative to the body 622 to enable a snap-fit connection between the second retainer portion 617 of the housing module 620 and the fourth retainer portion 626 of the attachment module 610.

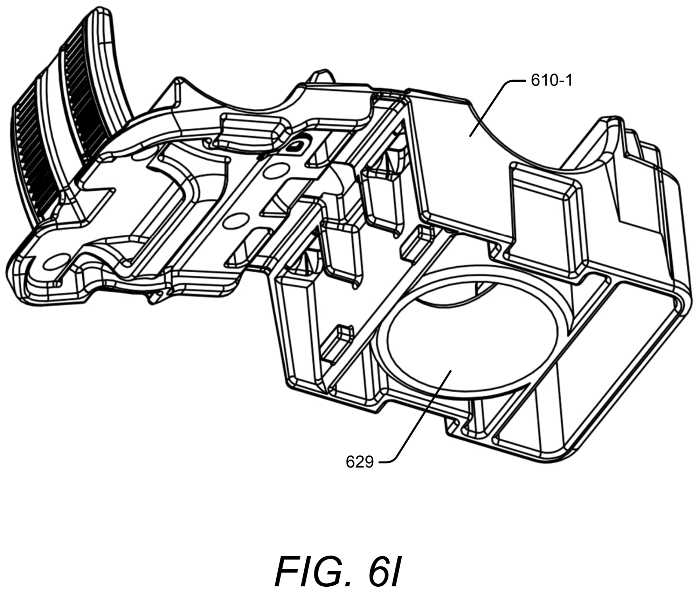

The attachment module 610 may define a countersink and through hole 688 configured to be aligned with a fastener receiving chamber (counterbore 629) of the second attachment module 610-1, illustrated in FIG. 6I, which may provide for a mount connection to a support pipe or a cable while also sensing it.

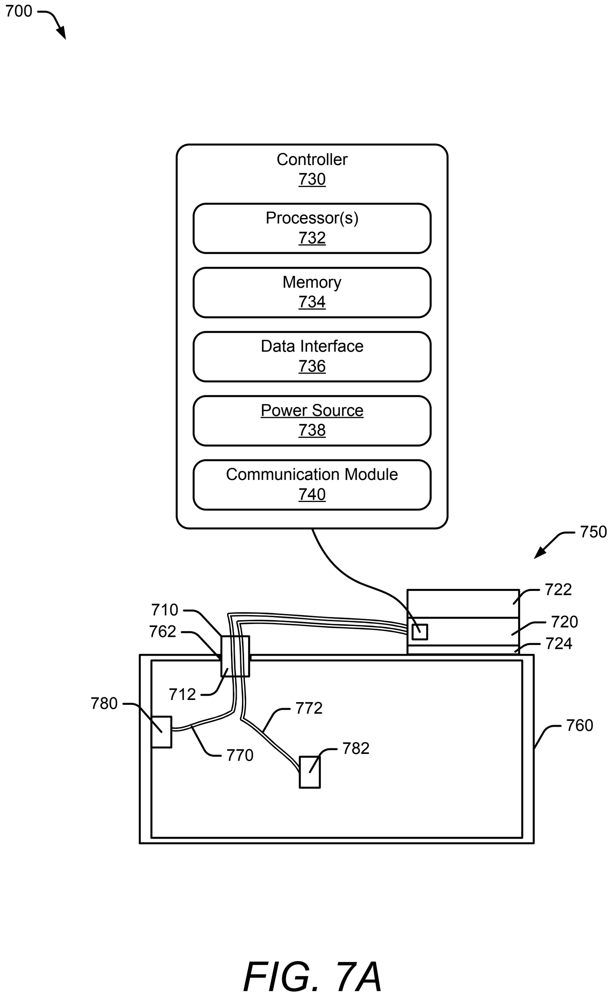

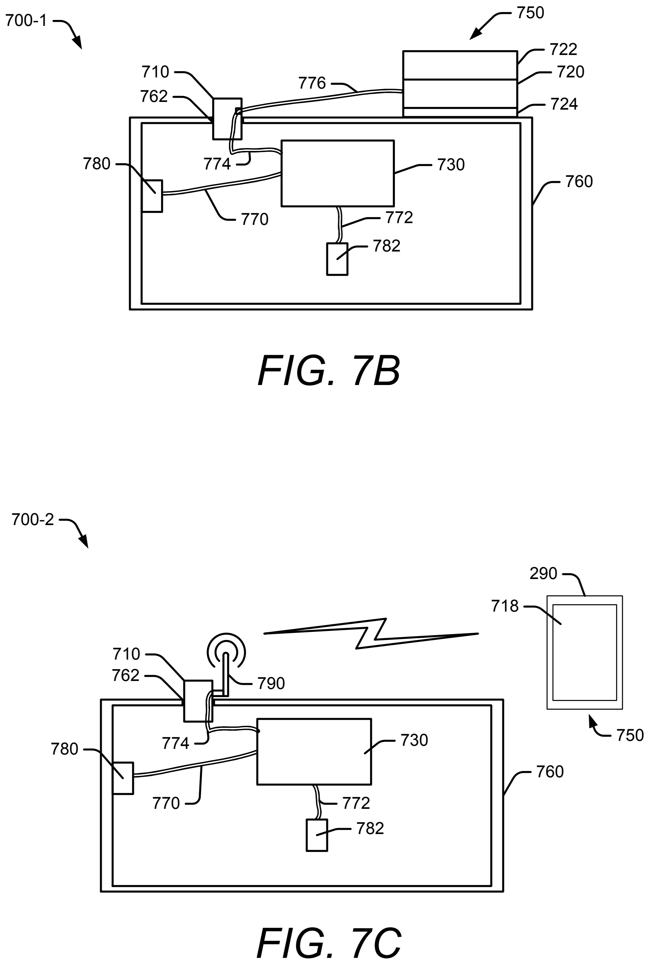

FIG. 7A is a schematic representation of another aspect of a smart sensor mount system 700 (sensor system 700). The sensor system 700 is similar to the sensor systems illustrated in FIGS. 1-6F and described above, except as detailed below. Thus, the sensor system 700 may include one or more of an attachment module, a housing module (e.g., top cover 722, bottom cover 720), a controller 730, processor(s) 732, memory 734, a data interface 736, a power source 738, a communication module 740, a notification module 750, and/or a sensor module (e.g., sensor 780, sensor 782). Additional alternative implementations of sensor systems are described below and illustrated in FIGS. 7B and 7C.

The sensor system 700 is configured for attachment to an object via an attachment module. In FIG. 7A, the object illustrated is an industrial automation cabinet 770 (e.g., control panel, electrical panel) that includes one or more electrical and/or electronic components (e.g., programmable logic controllers (PLC), input/output modules, human-machine interfaces (HMI), sensors, power components, circuit protection components, contactors, relays, terminal blocks, busbars, Deutsches Institut für Normung (DIN) rails, and the like). The attachment module is a cord grip 710 (e.g., a cable gland, cable strain relief, cable connector) that is configured for installation in an orifice 762 defined in a surface of the cabinet 760 (e.g., a top of the cabinet). The cord grip 710 may be configured to protect at least one cable that extends through the orifice 762.

In FIG. 7A, at least one sensor (e.g., first sensor 780, second sensor 782) is positioned within the cabinet 760. For example, the first sensor 780 may be an ambient air temperature sensor mounted in the cabinet 760 and the second sensor 782 may be a cable temperature sensor mounted on a cable within the cabinet. Cables (e.g., first cable 770, second cable 772) connect with the sensors and extend through a cable passageway 712 defined through the cord grip 710 to pass out of the cabinet 760. In the aspect illustrated in FIG. 7A, the cables operably connect with a notification module 750 that is provided within a housing that includes a top cover 722 and a bottom cover 720. The housing (e.g., top cover 722) may include a translucent, semi-translucent, and/or transparent portion that is configured to permit a notification light (e.g., from the notification module 250) to be visible to a user. The housing (e.g., bottom cover 720) may be configured to connect with a support surface (e.g., via a magnetic mount, adhesive, etc.) of the cabinet 760. The housing may include a mechanism (e.g., an indent in at least one of the top or bottom covers) that enables a user (e.g., using a screwdriver or other pry tool) to disconnect the covers from one another to access the cavity inside of the housing.

A connector module 724 (e.g., a magnet connector, a mechanical fastener, an adhesive portion) may be utilized to connect the notification module 750 to an external portion of the cabinet 760 or another location outside of the cabinet 760. The notification module 750 is configured to provide a notification to a user.

The notification module 750 may include a controller 730 (e.g., controller 230) that is configured for one or more of the functions of the sensor system 700. For example, the controller 730 may enable the interpretation of sensor data from the sensors. The controller 730 may be configured to receive sensor signals (sensor data) generated by at least one sensor (e.g., sensor 780, sensor 782) and process the sensor signals to generate processed signals. In one aspect, the controller 730 is configured to receive sensor signals generated by the sensors and process the sensor signals to: compare the sensor signals to a threshold value to determine if the sensor signals exceed a threshold, and responsive to a determination that the sensor signals exceed the threshold, generate a notification signal. The notification signal may trigger one or more of: an auditory alarm output by an electroacoustic transducer of the notification module 750; a vibratory alarm output by a vibration mechanism of the notification module 750; a visual alarm output by a light emitter of the notification module 750; a visual alarm output on a display of the notification module 750; or a notification message delivered to an application installed on a user device (e.g., computing device 290). In this way, the sensor system 700 is configured to monitor the sensors located within the cabinet 760 without needing to tap into the control panel to utilize a PLC or power supply. For example, on-mount LED indication and/or audible alarms may indicate to personnel passing by the notification module 750 that a thermal event has occurred. In this way, the sensors can be powered and the controller 730 can be operated without needing to utilize a controller (e.g., PLC) and/or a power source located within the cabinet 760.

FIG. 7B illustrates sensor system 700-1, which is similar to the sensor system 700 illustrated in FIG. 7A and described above, except as detailed below. The sensor system 700-1 includes a notification module 750 provided within a housing that includes a top cover 722 and a bottom cover 720. A connector module 724 (e.g., a magnet connector, a mechanical fastener, an adhesive portion) may be utilized to connect the notification module 750 to an external portion of the cabinet 760 or another location outside of the cabinet 760. In FIG. 7B, the sensors (e.g., sensor 780, sensor 782) operably connect (e.g., via cables 770, 772) with a controller 730, which may be located within the cabinet 760. The controller 730 may be configured to receive sensor signals (sensor data) and process the sensor signals to generate processed signals. For example, the controller 730 may be configured to receive sensor signals generated by the sensors and process the sensor signals to: compare the sensor signals to a threshold value to determine if the sensor signals exceed a threshold, and responsive to a determination that the sensor signals exceed the threshold, generate a notification signal. The notification signal may trigger one or more of: an auditory alarm output by an electroacoustic transducer of the notification module 750; a vibratory alarm output by a vibration mechanism of the notification module 750; a visual alarm output by a light emitter of the notification module 750; a visual alarm output on a display of the notification module 750; or a notification message delivered to an application installed on a user device (e.g., computing device 290). The connector 724 on the cord grip 710 may include a data interface that is communicatively coupled to the communication module of the controller 730 (e.g., via cable 774) and configured to communicatively connect with the notification module 750 via a cable 776.

FIG. 7C illustrates sensor system 700-2, which is similar to the sensor systems described above and illustrated in FIGS. 7A and 7B, except as detailed below. The sensor system 700-2 includes a notification module 750 provided via a user device (e.g., computing device 290), for example via an application 718 installed on the user device. The sensors (e.g., sensor 780, sensor 782) operably connect (e.g., via cables 770, 772) with a controller 730, which may be located within the cabinet 760. The controller 730 may be configured to receive sensor signals (sensor data) and process the sensor signals to generate processed signals. For example, the controller 730 may be configured to receive sensor signals generated by the sensors and process the sensor signals to: compare the sensor signals to a threshold value to determine if the sensor signals exceed a threshold, and responsive to a determination that the sensor signals exceed the threshold, generate a notification signal. The notification signal may trigger one or more of: an auditory alarm output by an electroacoustic transducer of the notification module 750; a vibratory alarm output by a vibration mechanism of the notification module 750; a visual alarm output by a light emitter of the notification module 750; a visual alarm output on a display of the notification module 750; or a notification message delivered to an application installed on a user device (e.g., computing device 290).

The connector 724 on the cord grip 710 may include an antenna port that is communicatively coupled to the communication module of the controller 730 (e.g., via cable 774) and configured to communicatively connect with an external antenna (e.g., antenna 790 illustrated in FIG. 7C), which is configured to transmit a radio frequency signal to a user device (e.g., computing device 290).

The controller 730 may further store sensor signals (sensor data) in a memory 734 (illustrated in FIG. 7A). In this way, the sensor system 700-2 may operate as a datalogger, logging sensor data. Logged sensor data and other information may be sent by the controller 730 via the communication module 740 (illustrated in FIGS. 7A) to the user device.

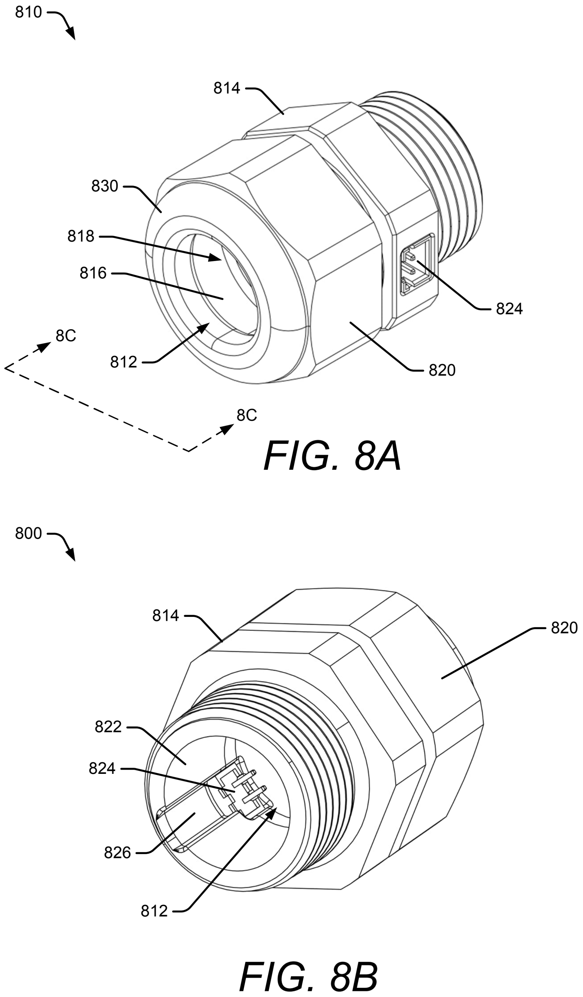

FIGS. 8A and 8B illustrate an example cord grip 800 configured for use with the sensor systems illustrated and described with respect to FIGS. 7A-7C. The cord grip 810 defines a passageway 812 therethrough, which is configured to receive one or more cables or other elongated objects.

The cord grip 810 includes a body portion 814 that is configured to pass through the orifice 762 (illustrated in FIGS. 7A-7C). The body portion 814 may be threaded and configured to receive a lock nut (not illustrated) to secure the cord grip 810 within the orifice. The cord grip 810 may include a sealing ring 816 (e.g., grommet) that is configured to compress around the cable(s) to seal against moisture, dust, and other contaminants. The cord grip 810 may include one or more collet fingers 818 that clamp down on the cable(s) for grip and a compression nut 820 that is configured to tighten to compress the sealing ring 816 and/or collet fingers 818 onto the cable. The passageway 812 of the cord grip 810 includes a sidewall 822 through which a connector 824 passes. The connector 824 may include a radio frequency (RF) connector (e.g., a coaxial RF connector, a Subminiature version A (SMA) connector, an N-type connector, a Bayonet Neill-Concelman (BNC) connector, a Threaded Neill-Concelman (TNC) connector, an F-type connector, and the like) that is configured to connect with a coaxial cable that extends to an antenna or an antenna with a mating coaxial connector. The connector 824 may include a device connector (e.g., a pin connector, a Solderless Terminal (JST) connector, a barrel connector, a USB connector, and the like) configured to receive a mating connector (e.g., to connect with a cable or component). In FIGS. 8A and 8B, the connector 824 is a pin connector. In aspects, the connector 824 is an antenna port that is communicatively coupled to the communication module 740 of the controller 730, the antenna port configured to communicatively connect with an external antenna (e.g., antenna 790 illustrated in FIG. 7C), which is configured to transmit a radio frequency signal to a user device (e.g., computing device 290).

A channel 826 (e.g., internal routing) may be defined in the sidewall 822. The channel 826 may extend to the connector 824 and may be configured to receive a cable (not illustrated) connected to the connector 824 and guide the cable through the passageway 812.

In aspects, the cord grip 810 may include a notification module 830. In the aspect illustrated, the notification module 830 is configured to attach to an opening of the passageway 812 at the compression nut 820. The notification module 830 may include a light-emitting diode (LED) module configured for illumination.

The parts of the disclosed apparatuses may be fabricated of any suitable material, including, but not limited to, a metal, a ceramic, a polymer (e.g., a polymeric material), and/or a composite. Suitable polymeric materials may include one or more of polyamide (PA), polypropylene (PP), polyethylene (PE), polyphenylene sulfide (PPS), polyether ether ketone (PEEK), polyaryletherketone (PAEK), ethylene tetrafluoroethylene (ETFE), polyacetal (POM), polybutylene terephthalate (PBT), ultraviolet stabilized polyacetal (POMUV), acrylonitrile styrene acrylate (ASA), polyester (PET), polyvinyl chloride (PVC), cross-linked thermoplastics, partially cross-linked thermoplastics, higher-temperature resins, ultraviolet (UV) resistant resins, other thermoplastic materials, and the like, and copolymers, blends, or alloys thereof)) as well as fiber-reinforced materials. A suitable polymeric material may include one or more additives (e.g., heat stabilizers (e.g., copper iodide), impact modifiers (e.g., polyolefin, urethane, rubber), UV stabilizers (e.g., carbon black, hindered amine light stabilizers (HALS)), flame retardants (e.g., nitrogen-based halogen-free flame retardants, melamine cyanurate, melamine borate, ammonium polyphosphate), colorants, and the like). One or more of the parts of the disclosed apparatuses may be formed of the same material as the other parts, or of a different material than the other parts. One or more of the parts of the apparatuses may be integrally formed of a suitable material(s) through one or more of an injection-molding process, an additive manufacturing process (e.g., a fused deposition modeling (FDM) process, a fused deposition modeling (FDM) process, a three-dimensional (3D) printing process), or another suitable process. One or more parts of the disclosed apparatuses may include a translucent and/or transparent material that is configured to permit a notification light to be visible therethrough.

Some additional examples of techniques and apparatuses for smart sensor mount systems are described in the following Examples.

Example 1. A sensor system comprising: an attachment module configured to attach to an object, the attachment module comprising: a first side opposite a second side; a first retainer portion defined on the first side; and a second retainer portion defined on the second side; and a housing module configured to connect with the attachment module, the housing module comprising: a third retainer portion configured to connect with the first retainer portion; and a fourth retainer portion configured to connect with the second retainer portion.

Example 2. The sensor system of Example 1, wherein the sensor system further comprises: a notification module configured to provide a notification to a user.

Example 3. The sensor system of Example 2, wherein the notification module is disposed in the housing module.

Example 4. The sensor system of Example 2, wherein the notification module further comprises: a controller configured to receive sensor signals generated by at least one sensor module and process the sensor signals to at least one of: (a) compare the sensor signals to a threshold value to determine if the sensor signals exceed a threshold, and responsive to a determination that the sensor signals exceed the threshold, generate a notification signal for the notification module; or (b) determine if the sensor signals deviate from a baseline, and responsive to a determination that the sensor signals deviate from a baseline, generate a notification signal for the notification module.

Example 5. The sensor system of Example 4, wherein the notification comprises at least one of: an auditory alarm output by an electroacoustic transducer of the notification module; a vibratory alarm output by a vibration mechanism of the notification module; a visual alarm output by a light emitter of the notification module; a visual alarm output on a display of the notification module; or a notification message delivered to an application installed on a computing device.

Example 6. The sensor system of Example 2, wherein the sensor system further comprises: a communication module configured to communicate a notification signal to the notification module.

Example 7. The sensor system of Example 1, wherein the housing module further comprises: a communication module configured to transmit data; and a controller configured to receive sensor signals generated by at least one sensor module.

Example 8. The sensor system of Example 7, wherein the controller is configured to process the sensor signals to generate processed signals and control the communication module to communicate at least one of the sensor signals or the processed signals.

Example 9. The sensor system of Example 8, wherein the communication module is configured to communicate signals to a computing device, the signals comprise at least one of the sensor signals or the processed signals.

Example 10. The sensor system of Example 7, wherein the communication module is a wireless communication module, the wireless communication module configured to transmit information to a computing device, the information including at least one of: the sensor signals generated by at least one sensor module; sensor signals processed by the controller; or a notification generated by a notification module.

Example 11. A sensor system comprising: a cord grip configured for installation in an orifice defined in a surface, the cord grip comprising: a sidewall; and a connector defined in the sidewall, the connector communicatively coupled to a communication module and configured to communicatively connect with an external antenna configured to transmit a radio frequency signal to a computing device.

Example 12. The sensor system of Example 11, further comprising: a housing module comprising: the communication module; and a controller and configured to receive sensor signals generated by at least one sensor module; an attachment module configured to attach the housing module to an object; and at least one sensor module configured to generate sensor signals.

Example 13. The sensor system of Example 12, wherein the at least one cable that extends through the orifice extends between the controller and the at least one sensor module.

Example 14. The sensor system of Example 12 further comprising: a notification module configured to provide a notification to a user, and the communication module is further configured to communicate a notification signal to the notification module.

Example 15. The sensor system of Example 14, wherein the cord grip further comprises a housing and the notification module is disposed in the housing.

Example 16. The sensor system of Example 14, wherein the controller is further configured to process the sensor signals to at least one of: (a) compare the sensor signals to a threshold value to determine if the sensor signals exceed a threshold, and responsive to a determination that the sensor signals exceed the threshold, generate a notification signal for the notification module; or (b) determine if the sensor signals deviate from a baseline, and responsive to a determination that the sensor signals deviate from a baseline, generate a notification signal for the notification module.

Example 17. The sensor system of Example 16, wherein the notification comprises at least one of: an auditory alarm output by an electroacoustic transducer of the notification module; a vibratory alarm output by a vibration mechanism of the notification module; a visual alarm output by a light emitter of the notification module; a visual alarm output on a display of the notification module; or a notification message delivered to an application installed on a computing device.

Example 18. The sensor system of Example 12, wherein the communication module is a wireless communication module.

Example 19. The sensor system of Example 18, wherein the wireless communication module is configured to transmit information to a computing device, the information including at least one of: the sensor signals generated by at least one sensor module; sensor signals processed by the controller; or a notification generated by a notification module.

Example 20. The sensor system of Example 19, wherein the cord grip further comprises: a notification module configured to provide the notification to a user, the controller is further configured to process the sensor signals to compare the sensor signals to a threshold value to determine if the sensor signals exceed a threshold, and responsive to a determination that the sensor signals exceed the threshold, the controller is configured to control the notification module to generate a notification.

Unless context dictates otherwise, use herein of the word "or" may be considered use of an "inclusive or," or a term that permits inclusion or application of one or more items that are linked by the word "or" (e.g., a phrase "A or B" may be interpreted as permitting just "A," as permitting just "B," or as permitting both "A" and "B"). Also, as used herein, a phrase referring to "at least one of" a list of items refers to any combination of those items, including single members. For instance, "at least one of a, b, or c" can cover a, b, c, a-b, a-c, b-c, and a-b-c, as well as any combination with multiples of the same element (e.g., a-a, a-a-a, a-a-b, a-a-c, a-b-b, a-c-c, b-b, b-b-b, b-b-c, c-c, and c-c-c, or any other ordering of a, b, and c). Further, items represented in the accompanying figures and terms discussed herein may be indicative of one or more items or terms, and thus reference may be made interchangeably to single or plural forms of the items and terms in this written description.

In this description of aspects of marking labels, ordinal numbers such as "first" and "second" are used only to distinguish between different described objects and have no limitation on a location, a sequence, a priority, a quantity, content, or the like of the described objects. For example, a "first connector" is used as an example, and there may be one or more "connectors." Additionally, objects modified by different ordinal numbers may be the same or different objects. For example, if the described object is a "retainer portion," a "first retainer portion" and a "second retainer portion" may be the same or different retainer portions.

In aspects, techniques and apparatuses for smart sensor mount systems may include one or more of the features of the techniques and apparatuses illustrated in the Drawings and described herein. Although implementations for techniques and apparatuses have been described in language specific to certain features and/or methods, the subject of the appended claims is not necessarily limited to the specific features or methods described. Rather, the specific features and methods are disclosed as example implementations of the techniques and apparatuses.

## Claims

1. A sensor system comprising:
an attachment module configured to attach to an object, the attachment module comprising:
a first side opposite a second side;
a first retainer portion defined on the first side; and
a second retainer portion defined on the second side; and
a housing module configured to connect with the attachment module, the housing module comprising:
a third retainer portion configured to connect with the first retainer portion; and
a fourth retainer portion configured to connect with the second retainer portion.

2. The sensor system of claim 1, wherein the sensor system further comprises:
a notification module, in particular with a controller, configured to provide a notification to a user, in particular with the notification module disposed in the housing module.

3. The sensor system of claim 2, wherein the sensor system further comprises:
a communication module configured to communicate the notification signal to the notification module.

4. The sensor system of claim 1, wherein the housing module further comprises:
a communication module configured to transmit data; and
a controller configured to receive sensor signals generated by at least one sensor module.

5. The sensor system of claim 4, wherein the controller is configured to process the sensor signals to generate processed signals and control the communication module to communicate at least one of the sensor signals or the processed signals.

6. The sensor system of claim 5, wherein the communication module is configured to communicate signals to a computing device, the signals comprise at least one of the sensor signals or the processed signals.

7. A sensor system comprising:
a cord grip configured for installation in an orifice defined in a surface, the cord grip comprising:
a sidewall; and
a connector defined in the sidewall, the connector communicatively coupled to a communication module and configured to communicatively connect with an external antenna configured to transmit a radio frequency signal to a computing device.

8. The sensor system of claim 7, further comprising:
a housing module comprising:
the communication module; and
a controller and configured to receive sensor signals generated by at least one sensor module;
an attachment module configured to attach the housing module to an object; and
at least one sensor module configured to generate sensor signals.

9. The sensor system of claim 8, wherein the at least one cable that extends through the orifice extends between the controller and the at least one sensor module.

10. The sensor system of claim 8, further comprising:
a notification module configured to provide a notification to a user, and the communication module is further configured to communicate a notification signal to the notification module, in particular with the cord grip further comprising a housing and the notification module being disposed in the housing.

11. The sensor system of claim 2 or 10, wherein the controller is configured to process the sensor signals to at least one of:
compare the sensor signals to a threshold value to determine if the sensor signals exceed a threshold, and
responsive to a determination that the sensor signals exceed the threshold, generate a notification signal for the notification module; or
determine if the sensor signals deviate from a baseline, and
responsive to a determination that the sensor signals deviate from a baseline, generate a notification signal for the notification module.

12. The sensor system of claim 11, wherein the notification signal comprises at least one of:
an auditory alarm output by an electroacoustic transducer of the notification module;
a vibratory alarm output by a vibration mechanism of the notification module;
a visual alarm output by a light emitter of the notification module;
a visual alarm output on a display of the notification module; or
a notification message delivered to an application installed on a computing device.

13. The sensor system of claim 4 or 8, wherein the communication module is a wireless communication module.

14. The sensor system of claim 13, wherein the wireless communication module is configured to transmit information to a computing device, the information including at least one of:
the sensor signals generated by at least one sensor module;
sensor signals processed by the controller; or
a notification generated by a notification module.

15. The sensor system of claim 14, wherein the cord grip further comprises:
a notification module configured to provide the notification to a user, the controller is further configured to process the sensor signals to at least one of:
compare the sensor signals to a threshold value to determine if the sensor signals exceed a threshold, and responsive to a determination that the sensor signals exceed the threshold, the controller is configured to control the notification module to generate a notification; or
determine if the sensor signals deviate from a baseline, and responsive to a determination that the sensor signals deviate from a baseline, generate a notification signal for the notification module.
